# EUROPEAN PATENT APPLICATION

(11) **EP 0 569 840 A1**
(43) Date of publication of application: **18.11.1993**
(21) Application number: 93107283.9
(22) Date of filing: 05.05.1993
(51) Int. Cl.: H01L 29/14

(54) **Quantum element**

(30) Priority: 12.05.1992 JP 118686/92
(71) Applicant: MATSUSHITA ELECTRIC INDUSTRIAL CO., LTD., Kadoma-shi, Osaka-fu, 571 (JP)
(72) Inventor: Okada, Kenji, Suita-shi (JP); Morimoto, Kiyoshi, Neyagawa-shi (JP); Udagawa, masaharu, Shibuya-ku, Tokyo (JP); Yuki, Koichiro, Neyagawa-shi (JP); Niwa, Masaaki, HIrakat-shi (JP); Hirai, Yoshihiko, Joto-ku, Osaka-shi (JP); Yasui, Jurou, Toyonaka-shi, (JP)
(74) Representative: Patentanwälte Leinweber & Zimmermann

(57) **Abstract**

Two quantum wires having different quantizing confinement axes are connected together through the intermediary of a quantum dot and tunnel barriers while their quantized conditions are maintained, thereby a plurality of quantum elements can be coupled together with their quantum conditions are held.

## Description

### BACKGROUND OF THE INVENTION

### Field of the Invention

The present invention relates to a coupling between elements using a quantum effect.

### Related Art

During the recent progress of semiconductor devices, high integration and fineness in design therefor have been improved. As such fineness is improved, novel element structures different from conventional transistor structures have been required more and more. Accordingly, devices using a quantum effect have been proposed as such novel element structure. In order to induce a quantum effect, it is required to develop a technology for forming dots and fine wires having dimensions which are not much larger than wavelengths of electrons, and a technology for coupling the dots and fine wires in order to constitute a circuit.

Electrons can be quantized in a certain direction so that the energy levels thereof become discrete by setting the dimensions of a quantum element to that substantially equal to the wavelength of electrons in this direction. The so-called quantizing confinement axis extends in this direction. Quantum elements can be sorted into three classifications, that is, one dimensional system in which quatization or confinement is made along an axis in one of three dimensional direction, two dimensional system in which quatization is made along two axes in two of three dimensional directions, and three dimensional system in which quantization is made in three dimensional directions. In the one dimensional system, signal electrons are transmitted in directions of the axes along which no quantization is made. Accordingly, it is difficult to couple a plurality of quantum elements having different signal transmitting directions with one another since their quantizing confinement axes are not coincident with one another. For example, in the case of coupling between quantum wires having different quantizing confinement axes, signal electrons are all reflected, or transmitted directly in dependence upon dimensions of two quantum wires. Accordingly, in order to transmit a substantial part of electrons, a certain specific device, that is, a device for converting the quantizing confinement axes is required.

Up to now, various quantum elements for transmitting signal electrons have been proposed. For example, Japanese Patent Application No. 4-62854 discloses a process for forming a quantum wire or a quantum dot on a silicon substrate, in which a silicon substrate is etched so as to form a thin line-like or dot-like part which is then oxidized at its periphery so as to confine such silicon part with a silicon oxide film.

However, up to now, there has not yet been proposed a structure with which two quantum wires having different quantizing confinement axes are coupled together so as to transmit signal electrons from one to another quantum wires. Should signal electrons pass through a part of a quantum wire which is bent by a certain angle, the electrons scatter at the corners of the bent part by a large degree so that a part of electrons passing through one quantum wire can be transmitted to another quantum wire (the percentage of electrons transmitted from one to another quantum wire depends upon the sizes of the wires, and an electron energy). However, it is noted that the energy owned by the electrons is not conservative, and it cannot be controlled.

Specifically, in a one dimensional system, in the case of coupling between a first quantum wire having its longitudinal direction along the Z-axis and a second quantum wire having its longitudinal direction along the Y-axis, the quantization of the first quantum wire is made in the X-axial and Y-axial directions while the quantization of the second quantum wire is made in the X- and Z-axial directions. Accordingly, even though these quantum wires are coupled together, signal electrons cannot be transmitted from the first to second quantum wires, and vice versa since their quantizing confinement axes are not coincident with each other.

### SUMMARY OF THE INVENTIONS

The present invention is devised in order to solve the above-mentioned problems inherent to conventional quantum elements, and accordingly, one object of the present invention is to provide a quantum element having a structure in which quantum wires having different quantizing confinement axes are coupled to one another while their quantizing conditions are maintained.

To the end, according to the present invention, there is provided a quantum element in which more than two quantum wires are connected together through the intermediary of tunnel barriers and quantum dots.

In view of the foregoing arrangement, electrons confined and quantized in a first quantum wire can enter into a quantum dot having a size substantially equal to that of the quantum wire through the intermediary of a tunnel barrier, in an axial direction other than its advancing direction, and then they enter into a second quantum wire through another barrier from the quantum dot, in an axial direction other than the advancing direction, whereby electrons can be transmitted through the second quantum wire. Thereby it is possible to connect a plurality of quantum elements having different quantizing confinement axes while maintaining the quantized condition of electrons.

Other objects, features and advantages of the present invention will be more apparent from descriptions of a preferred embodiment which will be explained with reference to the drawings in which:

### BRIEF DESCRIPTION OF THE DRAWINGS

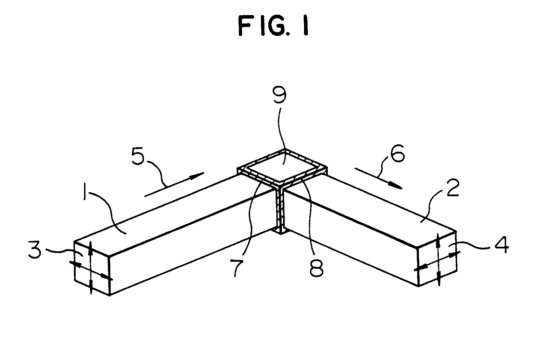

Fig. 1 is a perspective view illustrating one embodiment form of the present invention in which two quantum wires are connected by means of a quantum dot through the intermediary of barriers.

### DESCRIPTION OF PREFERRED EMBODIMENT

Referring to Fig. 1, a first quantum wire 1 has first quantizing confinement axes 3 while a second quantum wire 2 has second quantizing confinement axes 4. The first quantum wire 1 is coupled to one side of a quantum dot 9 through the intermediary of a first tunnel barrier 7 while the second quantum wire 2 is also connected to the quantum dot 9 at a side adjacent to the above-mentioned one side to which the first quantum wire 1 is connected, through the intermediary of a second tunnel barrier 8. As is clear from Fig. 1, the first tunnel barrier 7 and the second tunnel barrier 8 are orthogonal to each other, and accordingly, the first and second quantum wires are extended straight-forward, making a right angle to each other.

Next explanation will be made hereinbelow operation of the above-mentioned embodiment.

Signal electrons fed by a quantum element which is not shown and which is provided an upstream stage, are transmitted through the first quantum wire 1 in a first advancing direction 5. In this phase the electrons are quantized in axial directions indicated by the quantizing confinement axes 3, similar to that of the upstream stage quantum element. When the electrons reach the first tunnel barrier 7, the electrons are reflected by the barrier 7 or are transmitted therethrough. Whether the electrons are reflected or transmitted depends upon a quantized condition of the quantum dot 9 and a quantized condition of the first quantum wire. In the quantum dot 9, the electrons are quantized in the directions of the first quantizing confinement axes 3 and the first advancing direction 5, that is, they are confined in three axial directions, and the quantum dot 9 has dimensions in the directions of the first quantizing confinement axes 3, which are substantially coincident with that of the first quantum wire 1. Thus, the electrons in the first advancing direction 5, having a quantum level which coincides with the quantum level in the quantum dot 9 can pass through the first tunnel barrier 7.

Next, the electrons having entered in the quantum dot 9 are also reflected at the second tunnel barrier 8 or transmitted therethrough. Moreover, whether they are reflected or transmitted depends upon the quantum condition in the quantum dot 9 and in a quantum condition in the second quantum wire 2. In the quantum dot 9, the electrons are quantized in directions of the second quantizing confinement axes 4 and a second advancing direction 6, that is, they are quantized in three axial directions, and further, the dimensions of the quantum dot 9 in the directions of the second quantizing confinement axes 4 coincides with that of the second quantum wire 2. Thus, the electrons in the second advancing direction 6 having a quantum level which coincident with a quantum level in the second quantum wire 2 can pass through the second tunnel barrier 8. It is noted that no quantization is made in the second advancing direction 6 within the second quantum wire 2, and accordingly, substantially all electrons can be transmitted through the second tunnel barrier 8 so that they can run into a downstream stage quantum element which is not shown, by way of the second quantum wire 2. However, the quantization is made in the directions of the second quantizing confinement axes 4, and a quantized condition in which electrons are quantized in two axial directions while they are not quantized in one axial direction, is maintained although the confinement directions in the second quantum wire differ from that of the first quantum wire. Thus, as viewed from the downstream stage quantum element, the quantum condition is equivalent to that of the upstream stage quantum element.

Thus, according to the present invention, a plurality of quantum elements each having dimensions with which a quantum effect can be obtained, and having different quantizing confinement axes can be coupled together while their quantum conditions are maintained.

It should be note that the present invention will not be limited the above-mentioned embodiment alone. For example, although it has been explained that the two quantum wires are coupled together at a right angle through the intermediary of the quantum dot, two quantum wires can be coupled together at an angle other than a right angle within the scope of the present invention which will be defined in claims appended hereto.

## Claims

1. A quantum element comprising:
a first quantum wire having a first quantizing confinement axis;
a second quantum wire having a second quantizing confinement axis;
a quantum dot having first and second sides to which said first and second quantum wires are connected through the intermediary of first and second tunnel barriers, respectively.

2. A quantum element as set forth in claim 1, wherein said first and second quantum wires and said quantum dot are made of semiconductor materials, and said first and second barriers are made of insulating materials.

3. A quantum element as set forth in claim 1, wherein said first and second quantum wires and said quantum dot are made of semiconductor materials, and said first and second barriers are formed of heterojunctions.

4. A quantum element as set forth in claim 1, wherein said first and second quantum wires and said quantum dot are made of single crystal silicon, and the first and second tunnel barriers are formed of a silicon oxide film.
